(19) Europäisches Patentamt
European Patent Office
Office européen des brevets

(11) EP 4 418 404 A1

(12) **EUROPEAN PATENT APPLICATION**

(43) Date of publication:
**21.08.2024 Bulletin 2024/34**

(21) Application number: **23156523.5**

(22) Date of filing: **14.02.2023**

(51) International Patent Classification (IPC):
**H01M 10/42** (2006.01)  **H01M 10/48** (2006.01)
**G01R 31/36** (2020.01)

(52) Cooperative Patent Classification (CPC):
**H01M 10/48; G01R 31/367; G01R 31/392;**
**H01M 10/4285**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(71) Applicant: **TWAICE Technologies GmbH**
**80807 München (DE)**

(72) Inventor: **SINGER, Jan**
**81371 München (DE)**

(74) Representative: **Kraus & Lederer PartGmbB**
**Thomas-Wimmer-Ring 15**
**80539 München (DE)**

(54) **PRESSURE OR STRAIN ESTIMATION FOR RECHARGEABLE BATTERIES**

(57)   Various examples relate to characterizing ageing of a rechargeable battery. Multiple state of health associated with capacity, impedance, and/or pressure or strain can be determined, taking into consideration stress factors of the battery. A model is built that enables to determine the state of health of the battery associated with pressure or strain.

**FIG. 4**

**Description**

TECHNICAL FIELD

Various examples of the invention relate to techniques for characterizing a battery. In particular, various examples of the invention relate to techniques for determining/estimating an evolution of pressure or strain of a battery cell.

BACKGROUND

Rechargeable batteries such as lithium-ion batteries (LIBs) are the main choice of power source for portable electronics, grid energy storage systems, and electric vehicles (EVs). LIBs are also widely used in stationary energy storage, e.g., in connection with photovoltaic power plants.

According to various formats of battery cells, e.g., pouch, prismatic, or cylindrical, battery cells are constrained with a fixed force or arranged in a fixed housing during manufacturing. An initial cell pressure or strain (or stress) is applied either by the housing or clamping plates to ensure a good performance of battery cells.

Over the lifetime of a battery cell, the initial volume or even the cyclic volume change increase due to several ageing mechanisms. Such ageing mechanisms may comprise a growth of surface layers, gas evolution, change in porosity of the electrodes, lithium plating, etc. Those effects are irreversible. The resulting volume change is also irreversible.

As the volume of a battery cell changes/increases during a lifetime, the internal cell pressure increases and can affect the performance of the battery cell in a negative manner, e.g., affecting safety and undermining stability. The pressure can even increase up to critical values that either result in the sudden death of a cell or induce cracking of the cell housing.

SUMMARY

Therefore, there is a need for improved techniques for characterizing rechargeable batteries. In particular, there is a need for techniques that enable reliably and precisely determining/estimating an evolution of pressure or strain of a battery cell.

This need is met by the features of the independent claims. The features of the dependent claims define embodiments.

A computer-implemented method of characterizing ageing of a rechargeable battery is disclosed. The method includes, for each of at least one battery stress factor: obtaining multiple sets of pressure or strain values over a lifetime of a test cell of a rechargeable battery. The method also includes, for each of the at least one battery stress factor: determining a respective individual ageing function based on the respective multiple sets of pressure are strain values, wherein the respective individual ageing function describes a dependency of the pressure or strain values on the respective battery stress factor. The method also includes determining a cumulative ageing function based on all the individual ageing functions. The cumulative ageing function describes a dependency of the pressure strain values on each of the at least one battery stress factor.

A computer program including program code is disclosed. The program code can be executed by at least one processor. The at least one processor, upon loading and executing the program code, performs a method of characterizing ageing of a rechargeable battery. The method includes, for each of at least one battery stress factor: obtaining multiple sets of pressure or strain values over a lifetime of a test cell of a rechargeable battery. The method also includes, for each of the at least one battery stress factor: determining a respective individual ageing function based on the respective multiple sets of pressure are strain values, wherein the respective individual ageing function describes a dependency of the pressure or strain values on the respective battery stress factor. The method also includes determining a cumulative ageing function based on all the individual ageing functions. The cumulative ageing function describes a dependency of the pressure strain values on each of the at least one battery stress factor.

A computing device including a processor and a memory is disclosed. The memory stores program code. The at least one processor is configured to load and execute the program code. The at least one processor, upon loading and executing the program code, performs a method of characterizing ageing of a rechargeable battery. The method includes, for each of at least one battery stress factor: obtaining multiple sets of pressure or strain values over a lifetime of a test cell of a rechargeable battery. The method also includes, for each of the at least one battery stress factor: determining a respective individual ageing function based on the respective multiple sets of pressure are strain values, wherein the respective individual ageing function describes a dependency of the pressure or strain values on the respective battery stress factor. The method also includes determining a cumulative ageing function based on all the individual ageing functions. The cumulative ageing function describes a dependency of the pressure strain values on each of the at least one battery stress factor.

A computer-implemented method of characterizing ageing of a battery is disclosed. The method includes obtaining, for a battery, data indicative of occurrence of multiple battery stress factors over a monitoring time duration. The method also includes determining at least one first state of health of the battery associated with at least one of capacity or impedance of the battery based on the data indicative of occurrence of the multiple battery stress factors. The method further includes determining a second state of health of the battery associated with pressure or strain of the battery based on the data indicative of occurrence of the multiple battery stress factors.

A computer program including program code is disclosed. The program code can be executed by at least one processor. The at least one processor, upon loading and executing the program code, performs a method of characterizing ageing of a rechargeable battery. The method includes obtaining, for a battery, data indicative of occurrence of multiple battery stress factors over a monitoring time duration. The method also includes determining at least one first state of health of the battery associated with at least one of capacity or impedance of the battery based on the data indicative of occurrence of the multiple battery stress factors. The method further includes determining a second state of health of the battery associated with pressure or strain of the battery based on the data indicative of occurrence of the multiple battery stress factors.

A computing device including a processor and a memory is disclosed. The memory stores program code. The at least one processor is configured to load and execute the program code. The at least one processor, upon loading and executing the program code, performs a method of characterizing ageing of a rechargeable battery. The method includes obtaining, for a battery, data indicative of occurrence of multiple battery stress factors over a monitoring time duration. The method also includes determining at least one first state of health of the battery associated with at least one of capacity or impedance of the battery based on the data indicative of occurrence of the multiple battery stress factors. The method further includes determining a second state of health of the battery associated with pressure or strain of the battery based on the data indicative of occurrence of the multiple battery stress factors.

It is to be understood that the features mentioned above and those yet to be explained below may be used not only in the respective combinations indicated, but also in other combinations or in isolation without departing from the scope of the invention.

BRIEF DESCRIPTION OF THE DRAWINGS

FIG. 1A schematically illustrates exemplary evolution profiles of pressure or strain values over time/cycle for different SoC values.

FIG. 1B schematically illustrates exemplary evolution profiles of pressure or strain values over time/cycle for different T values.

FIG. 2 schematically illustrates individual ageing functions that link a respective stress factor to internal cell pressure.

FIG. 3 schematically illustrates a system according to various examples.

FIG. 4 is a flowchart of a method according to various examples.

FIG. 5 schematically illustrates a processing pipeline for determining a state of health associated with pressure or strain according to various examples.

FIG. 6 schematically illustrates a computing device according to various examples.

DETAILED DESCRIPTION

Some examples of the present disclosure generally provide for a plurality of circuits or other electrical devices. All references to the circuits and other electrical devices and the functionality provided by each are not intended to be limited to encompassing only what is illustrated and described herein. While particular labels may be assigned to the various circuits or other electrical devices disclosed, such labels are not intended to limit the scope of operation for the circuits and the other electrical devices. Such circuits and other electrical devices may be combined with each other and/or separated in any manner based on the particular type of electrical implementation that is desired. It is recognized that any circuit or other electrical device disclosed herein may include any number of microcontrollers, a graphics processor unit (GPU), integrated circuits, memory devices (e.g., FLASH, random access memory (RAM), read only memory (ROM), electrically programmable read only memory (EPROM), electrically erasable programmable read only memory (EEPROM), or other suitable variants thereof), and software which co-act with one another to perform operation(s) disclosed herein. In addition, any one or more of the electrical devices may be configured to execute a program code that is embodied in a non-transitory computer readable medium programmed to perform any number of the functions as disclosed.

In the following, embodiments of the invention will be described in detail with reference to the accompanying drawings. It is to be understood that the following description of embodiments is not to be taken in a limiting sense. The scope of the invention is not intended to be limited by the embodiments described hereinafter or by the drawings, which are taken to be illustrative only.

The drawings are to be regarded as being schematic representations and elements illustrated in the drawings are not necessarily shown to scale. Rather, the various elements are represented such that their function and general purpose become apparent to a person skilled in the art. Any connection or coupling between functional blocks, devices, components, or other physical or functional units shown in the drawings or described herein may also be implemented by an indirect connection or coupling. A coupling between components may also be established over a wireless connection. Functional blocks may be implemented in hardware, firmware, software, or a combination thereof.

Battery cells are breathing and swelling over their lifetime. A volume change and resulting pressure change be dangerous for safety and stability of the battery. At the least, it can influence the cell performance. Systems designer thus aim to understand and forecast the pressure evolution of the lifetime of a battery cell.

Techniques related to determining/estimating an evolution of pressure or strain of rechargeable batteries are described below.

A semi-empirical strain/pressure change model is disclosed. Measurements of pressure or strain values can be taken across the lifetime of a battery, e.g., in laboratory measurements. The model is then parametrized based on these measurements. The model can then be used to make predictions for a battery.

A workflow including lab data generation (measurement phase), parameter fit of functions and equations to build a model (model building phase), and model application is disclosed (application phase).

Lab data generation includes laboratory measurements. The dependency of the pressure or strain on multiple stress factors is determined. Calendric change of the pressure or strain (over time) or cyclic change of the pressure or strain (over charge throughput or charge-discharge cycles) is measured.

According to various examples, the pressure or strain values of a battery cell include external pressure/strain values and/or internal pressure/strain values.

For example, the external pressure/strain values may be measured in the measurement phase using a load cell in a constant way setup, i.e., the battery cell is constrained with a load cell and thereby a force evolution over a lifetime may be monitored. For example, multiple sets of the external pressure/strain values may be measured against various stress factors such as state of charges (SoCs), depths of discharge (DoDs), charging rates (C-rates), and temperatures, respectively, during an accelerated test. Alternatively or optionally, the external pressure/strain values may be measured using a displacement sensor in a constant force setup, i.e., the battery cell is constrained with springs and displacement sensors and thereby thickness measurements of the battery cell can be obtained in the lifetime of the battery cell.

The internal pressure/strain values may be obtained by direct measurements of the pressure in a battery cell case. Such direct measurements can be obtained from battery pressure monitoring sensors deployed inside the battery cell.

In general, the techniques described herein can be used to characterize either calendar ageing or cycle ageing of a battery. Alternatively or optionally, the techniques can also be used to characterize both calendar ageing and cycle ageing of a battery.

Depending on which ageing is considered, respective models and functional dependencies are built for time t (calendric ageing) or charge throughput Ah or charge discharge cycles n (cyclic ageing). The same functional dependencies can be used where these variables are simply exchanged.

Accelerated testing may be conducted by elevating at least one of battery stress factors to increase the degradation rate and precipitate failure earlier than under normal operation.

According to various examples, the at least one battery stress factor may comprise an SoC and a T. An exemplary list of a calendar ageing test conditions can be found in Table 1 below.

| T \ SoC | 10% | 20% | 30% | 40% | 50% | 60% | 70% | 80% | 90% | 100% |
|---|---|---|---|---|---|---|---|---|---|---|
| 50 °C | X | X | X | | X | X | X | X | X | X |
| 45 °C | | | | | X | | | | | |
| 40 °C | | | | | X | | | | | |
| 35 °C | | | | | X | | | | | |

*Table 1: Test matrix of calendar ageing tests. For each "X", a pressure or strain value is measured.*

As highlighted in Table 1 using **"X",** four different T values, i.e., 35 °C, 40 °C, 45 °C, and 50 °C, are tested to verify a temperature dependency of the pressure or strain, and nine different SoC values, i.e., 10%, 20%, 30%, 50%, 60%, 70%, 80%, 90%, and 100%, are tested to verify an SoC dependency. Each combination of a T value and an SoC value, e.g., (50 °C, 30%) and (50 °C, 80%), in the calendar ageing test may comprise one or more cells of the same battery to get one or more sets of the pressure or strain values. If more cells of the same battery are used, the pressure or strain values may be determined by averageing individual pressure or strain values measured for each of the more cells. Every k (e.g., k=1, 2, 3, 4, 5, or 6) weeks (or hours, days, months) the pressure or strain of the one or more test cell is measured.

According to various examples, the at least one battery stress factor includes an SoC and a DoD. An exemplary list of all cycle ageing test conditions can be found in Table 2 below.

| DoD \ SoC | 10% | 20% | 30% | 40% | 50% | 60% | 70% | 80% | 90% | 100% |
|---|---|---|---|---|---|---|---|---|---|---|
| 80% | X | X | X | | X | X | X | X | X | X |
| 60% | | | | | X | | | | | |
| 40% | | | | | X | | | | | |
| 20% | | | | | X | | | | | |

*Table 2: Test matrix of cycle ageing tests. For each "X", a pressure or strain value is measured..*

As highlighted in Table 2 using **"X",** four different DoD values, i.e., 20%, 40%, 60%, and 80%, are tested to verify a DoD dependency, and nine different average SoC values, i.e., 10%, 20%, 30%, 50%, 60%, 70%, 80%, 90%, and 100%, are tested to verify an SoC dependency. Each combination of a DoD value and an SoC value, e.g., (40%, 50%) and (60%, 50%), in the cycle ageing test may comprise one or more cells of the same battery to get one or more sets of the pressure or strain values. If more cells of the same battery are used, the pressure or strain values may be determined by averageing individual pressure or strain values measured for each of the more cells. Every m (e.g., m=1, 2, 3, 4, 5, or 6) cycles the pressure or strain of the one or more test cell is measured.

Similar to the calendar ageing test, after performing the cycle ageing test based on the test conditions of Table 2, evolution profiles of pressure or strain values over time/cycle for different DoD values and different SoC values may be determined, respectively.

Table 1 and Table 2 are only examples. Many other laboratory tests can be setup. Various batteries can be tested.

The techniques described herein can be used in connection with a wide range of different battery types, for example in connection with lithium-ion-based batteries, such as lithium-nickel-manganese-cobalt oxide batteries or lithium-manganese-oxide batteries. Other examples include sodium ion batteries.

The batteries described herein can be used in various applications (application phase), for example for batteries used in devices such as motor vehicles or drones or portable electronic devices such as mobile phones. It would also be possible to use the batteries described herein in the form of stationary energy storage devices.

The techniques described here allow the characterization of the battery to be carried out on the basis of pressure or strain evolution prediction of the battery. This means that the state of the battery can be predicted for a certain prediction interval or time point in the future. In particular, a state of health (SOH) associated with pressure or strain of the battery can be predicted/estimated for the prediction interval or time point.

According to disclosed examples, a cumulative ageing function is determined based on a respective individual ageing function associated with each of at least one battery stress factor. The cumulative ageing function describes a dependency of pressure or strain values of a test cell of the rechargeable battery on each of the at least one battery stress factor. For each of at least one battery stress factor, the respective individual ageing function is determined based on respective multiple sets of the pressure or strain (or stress) values. Laboratory measurements can be executed to determine the individual ageing function(s), cf. Table 1 and Table 2. The respective multiple sets of the pressure or strain values for each of at least one battery stress factor are obtained over a lifetime of the test cell of the rechargeable battery. The respective individual ageing function describes a dependency of the pressure or strain values on the respective battery stress factor.

The battery stress factors may comprise a state of charge (SoC), a depth of discharge (DoD), a C-rate, or a temperature (T), e.g., an ambient temperature.

Generally, SoC is defined as the ratio of battery remaining capacity to its nominal capacity. The SoC is a value between 0% and 100% that indicates the relative level of charge presently held by the battery. The units of SoC are percentage points. A SoC of 100% corresponds to a "full" battery, while a SoC of 0% corresponds to an "empty" battery.

The DoD may be defined as the maximum fraction or percentage of a battery's capacity (given in Ah) which is removed from the charged battery in a discharging process or on a regular basis. "Charged" does not necessarily refer to fully or 100 % charged, but rather to the SoC, where the battery charger stops charging. The DoD can also be defined as the fraction or percentage of the battery's capacity which is currently removed from the battery with regard to its (fully) charged state. For fully charged batteries, the DoD is connected to the SoC by the formula $DoD = 100\% - SoC$. The DoD then is the complement of the SoC: as one increases, the other decreases.

The speed of charging and discharging is described by C-rates. The capacity of a battery is commonly rated at 1C, meaning that a fully charged battery rated at 1 Ampere hour (Ah) should provide 1A for one hour. The same battery discharging at 0.5C should provide 500 milliamperes (mA) for two hours, and at 2C it delivers 2A for 30 minutes. A C-rate of 1C is also known as a one-hour discharge; 0.5C or C/2 is a two-hour discharge and 0.2C or C/5 is a 5-hour discharge. Some high-performance batteries can be charged and discharged above 1C with moderate stress. A C-rate can be determined as a mean across charging and discharging; or can be broken down into charging C-rate and discharging C-rate.

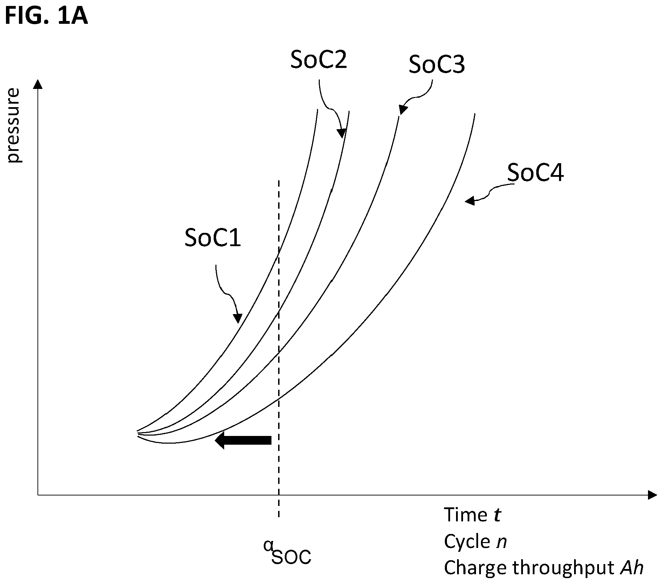

FIG. 1A schematically illustrates exemplary evolution profiles of pressure or strain values over time t, cycle n or charge throughput Ah for different SoC values $SoC_1$, $SoC_2$, $SoC_3$, and $SoC_4$. The pressure profiles over lifetime P = $f(SOC, Ah)$ are obtained at the same T, e.g., 50 °C as shown in Table 1. $f()$ denotes an arbitrary function operation throughout this disclosure.

Then, an individual ageing function $\alpha_{SOC}$ that describes a dependency of the pressure or strain values on SoC can be determined based on the evolution profiles of pressure or strain values over time/cycle for different SoC values $SoC_1$, $SoC_2$, $SoC_3$, and $SoC_4$. There is no dependency of time, cycle or charge throughput in the individual ageing function.

To determine the individual ageing function $\alpha_{SOC}$, a fitting process or optimization process can be employed for a certain ageing state of the battery (vertical dashed line in FIG. 1A). The individual ageing function can be considered to have a predefined functional shape (e.g., a polynomial functional dependency) and the parameters of the functional dependency can then be set. To determine such parameters, it would be possible to employ a machine-learning algorithm that has been pre-trained based on respective tasks.

This means that the pressure then is calculated over the lifetime by

$$P = \alpha_{SOC} f(Ah).$$

$$(1)$$

i.e., by separating the time/cycle variable Ah, t or n from the ageing function.

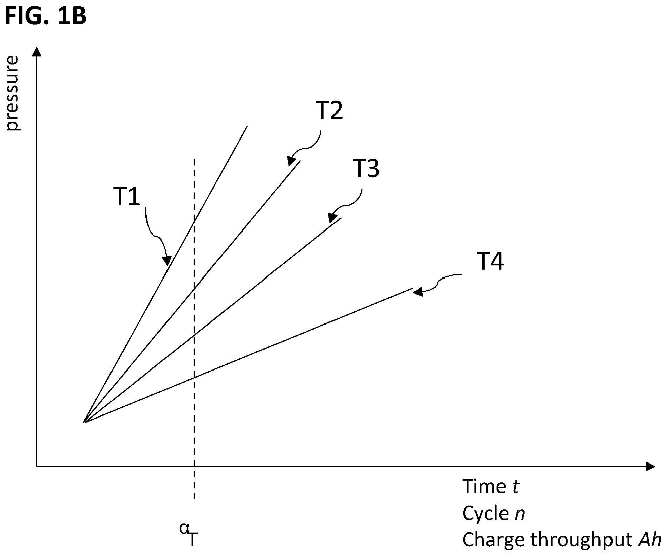

FIG. 1B schematically illustrates exemplary evolution profiles of pressure or strain values er time t, cycle n or charge throughput Ah for different T values $T_1$, $T_2$, $T_3$, and $T_4$. The profiles are obtained under the same SoC, e.g., 50% as shown in Table 1. Then, an individual ageing function $\alpha_T$ that describes a dependency of the pressure or strain values on T can be determined based on the evolution profiles of pressure or strain values over time/cycle for different T values $T_1$, $T_2$, $T_3$, and $T_4$.

This means that the pressure then is calculated over the lifetime by

$$P = \alpha_T f(Ah).$$

$$(2)$$

Equations 1 and 2 are expressed for charge throughput. They can be similarly expressed as functions of time (calendric ageing) or charge-discharge cycles (cyclic ageing).

Equations 1 and 2 describe the ageing functions for SOC and temperature. Similar individual ageing functions can be defined for other stress factors such as DoD $\alpha_{DOD}$, C-rate for charging $\alpha_{C\text{-}Ch}$ or C-Rate for discharging $\alpha_{C\text{-}Dh}$.

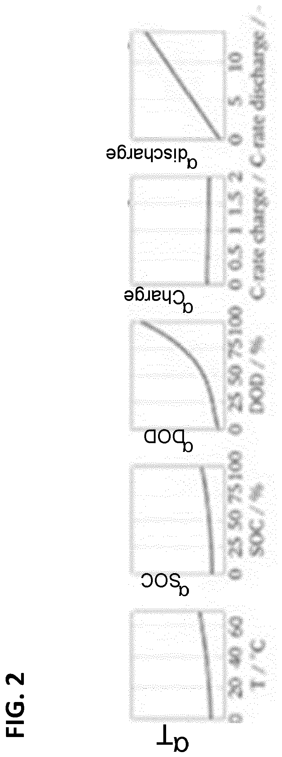

Example individual ageing functions are shown in FIG. 2. The individual ageing functions describe proportionalities for each individual ageing function. They can be empirically determined. For example, a neural network can be used or a fitting optimization. Typically, such individual ageing functions can be described by a polynomial function of 5th order up to 12th order.

For illustration, in FIG. 2 it is illustrated that the individual ageing function for temperatures (left most plot) shows a weak temperature dependency. This means that the pressure/strain is weakly dependent on temperature. A temperature increase increases the pressure/strain increase comparatively little, e.g., less severely than a DOD increase (middle plot in FIG. 2).

According to various examples, the respective individual ageing function is determined by fitting parameters of a predetermined parameterized function based on the respective multiple sets of the pressure or strain values. The predetermined parameterized function describes an evolution of the pressure or strain values over the respective battery stress factor. The predetermined parameterized functions can be polynomial functions of t-th order, e.g., with t=5...12.

These individual ageing functions sample the high dimensional space of stress factors locally and one-dimensional (considering only a single stress factor being applied). Hereinafter, techniques are disclosed which enable combining the individual ageing functions (cf. FIG. 2). More generally, techniques are disclosed that enable to combine multiple individual ageing functions associated with different stress factors into a cumulative ageing function. This is a high dimensional ageing function, due to the many (e.g., two to five or even more) stress factors considered. This ageing function may be referred to as cumulative ageing function, because it cumulatively considered the dependency on multiple stress factors.

Thus, as will be appreciated from the above, within the model building phase, examples disclosed herein utilize a two-step approach for determining an ageing function that describes a dependency of pressure or strain values over a lifetime of a battery on at least one battery stress factor, e.g., an SoC, a DoD, a C-rate, or a T. First, individual ageing functions are being fitted; then, the individual ageing functions are combined to form a cumulative ageing function. Accordingly, an evolution of pressure or strain of the battery can be reliably and precisely determined/predicted.

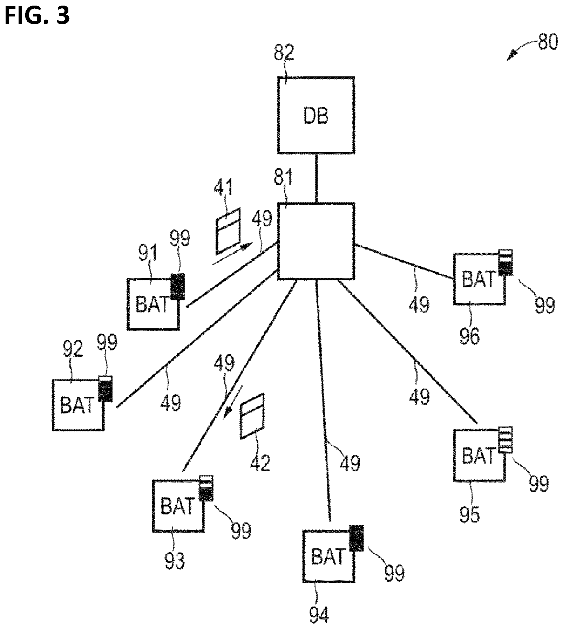

FIG. 3 illustrates aspects associated with a system 80. The system 80 comprises a computing device 81 which is connected to a database 82. In addition, the system 80 comprises communication connections 49 between the computing device 81 and each of several batteries 91-96. The communication connections 49 could be implemented, for example, via a local network or a cellular network.

In general, different battery types can be used in the various examples described herein. This means that the batteries 91-96 may comprise several types. Different types of batteries can be differentiated, for example, as relates to one or more of the following properties: shape of the cell (i.e., round cell, prismatic cell, etc.), cooling system (air cooling with active or passive design, coolant in coolant hose, passive cooling elements, etc.), the cell chemistry (e.g., electrode materials used, electrolytes, etc.), etc.

FIG. 3 illustrates by way of example that the batteries 91-96 can transmit state data 41 to the computing device 81 via the communication connections 49. For example, it would be possible for the state data 41 to be indicative of one or more operating values of the respective battery 91-96. This includes, e.g., time series of voltage and/or current and/or temperature. Alternatively or additionally, the state data 41 can also be indicated for of one or more stress factors of the battery, e.g., SoC values, DoD values, C-rate values, and/or T values. The state data 41 could be sent in an event-driven manner or according to a specified timing scheme.

Based on such state data 41, the internal pressure of the battery cell of the battery can be determined. Based on such state data 41, the state of health of each battery can be determined (in the application phase). The state of health of the battery can be determined with respect to capacity, i.e., a capacity fade can be determined. The state of health of the battery can - alternatively or additionally - be determined with respect to impedance, i.e., impedance-growth can be determined. In particular, the state of health according to examples is determined with respect to pressure/strain-growth. Such determining of the state of health associated with pressure/strain-growth is determined based on an empirically-parametrized cumulative ageing function that provides the pressure/strain as a function of one or more stress factors of the battery, e.g., state of charge, depth of discharge, temperature and so forth. The state of health prediction further depends on the current operating state of the battery, e.g., current capacity, current impedance, open circuit voltage, etc.

Techniques will be explained hereinafter regarding how to determine such cumulative ageing function as well as how to employ the cumulative ageing function to then determine the pressure/strain-associated state of health.

Based on the estimated state of health, it is possible to control the operation of each one of the batteries 91-96. For instance, if state of health degrades, it would be possible to apply restrictions or limitations to the operation of that battery 91-96. For instance, it would be possible to limit a charging rate or discharging rate. For example, it would be possible to limit the maximum SOC or limit the C-rate.

FIG. 3 also illustrates by way of example that the computing device 81 can send control data 42 to the batteries 91-96 via the communication connections 49. For example, the control data 42 can apply certain operating restrictions/constraints to the operation of the batteries, e.g., based on the estimated state of health. This avoids further degrading of the state of health beyond a tolerable threshold.

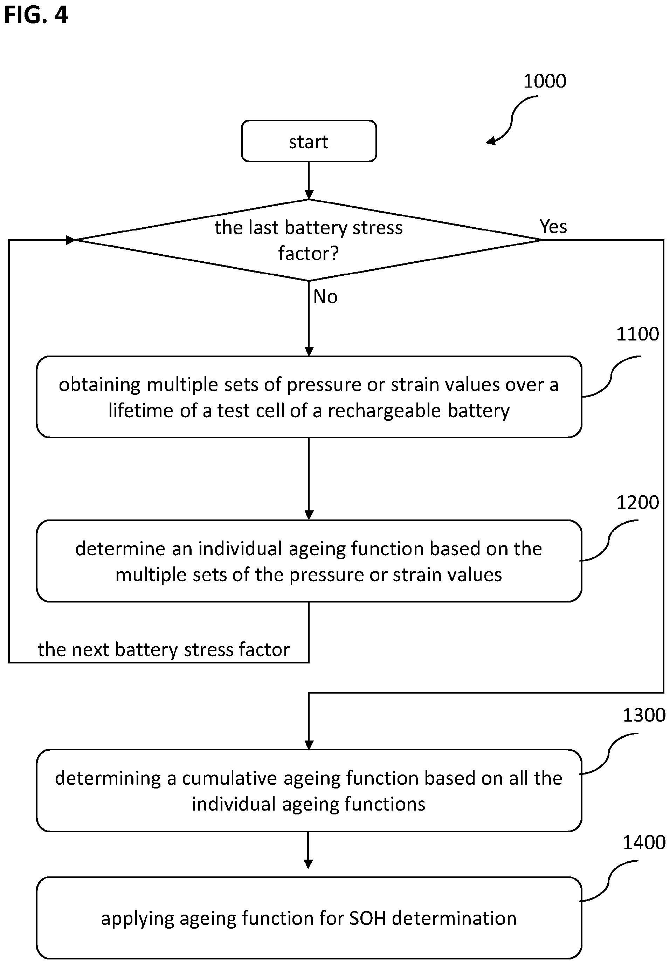

Next, techniques for characterizing rechargeable batteries, in particular, techniques that enable reliably and precisely determining/estimating an evolution of pressure or strain of a battery cell, e.g., a cell of the batteries 91-96, are described in connection with FIG. 4.

FIG. 4 is a flowchart of a method 1000 according to various examples. The method 1000 pertains to characterizing ageing of a rechargeable battery, e.g., battery 91 of FIG. 3.

In a first phase (up to box 1300; model building phase), a cumulative ageing function of the test cell is determined/built based on measurements obtained during either a calendar ageing test or a cycle ageing test (measurement phase). The cumulative ageing function is determined based on a respective individual ageing functions associated with each of at least one battery stress factor. The cumulative ageing function describes a dependency of pressure or strain values of a test cell of the rechargeable battery on each of the at least one battery stress factor. For each of at least one battery stress factor, the respective individual ageing function is determined based on respective multiple sets of the pressure or strain (or stress) values. The respective multiple sets of the pressure or strain values for each of at least one battery stress factor are obtained over a lifetime of the test cell of the rechargeable battery.

Here, lifetime means a significant fraction of the life cycle of the battery from start to end-of-life criterion, e.g., not less than 30% of the life cycle or not less than 60%.

The respective individual ageing function describes a dependency of the pressure or strain values on the respective battery stress factor.

In a second phase (box 1400), the pressure or strain ageing model can be put to use, i.e., used to determine the state of health associated with pressure/strain for a battery (in the application phase).

The method 1000 of FIG. 4 may be at least partly executed by the computing device 81, e.g., by a processor upon loading program code from a memory and upon executing the program code. Details with respect to the method 1000 will be described below.

At box 1100, multiple sets of pressure or strain values over a lifetime of a test cell of a rechargeable battery are obtained.

For example, the multiple sets of the pressure or strain values may be measured in a laboratory setup against various battery stress factors, such as SoCs, DoDs, C-rates, and temperatures, respectively, during an accelerated test. The accelerated test may be a calendar ageing test or a cycle ageing test. The accelerated test may be conducted based on a test matrix of calendar ageing tests or a test matrix of cycle ageing tests, cf. Table 1 and Table 2 for two examples.

According to various examples, each of the multiple sets of the pressure or strain values may be obtained based on case stress measurements of the test cell. For example, the case stress measurements may be obtained using a load cell as described above.

According to this disclosure, each of the multiple sets of the pressure or strain values is obtained during a cycling test or a calendric test of the test cell.

At box 1200, determine a respective individual ageing function based on the respective multiple sets of the pressure or strain values, and the respective individual ageing function describes a dependency of the pressure or strain values on the respective battery stress factor.

The respective individual ageing function, e.g., $\alpha_{SOC}$, etc. (cf. FIG. 2) can be determined using techniques as described above. For example, the respective individual ageing function may be determined by fitting parameters of a predetermined parameterized function based on the respective multiple sets of the pressure or strain values. The predetermined parameterized function describes an evolution of the pressure or strain values over the respective battery stress factor. Each individual ageing function is associated with a respective ageing factor that describes the proportionality between the respective stress factor and the impact onto the state of health.

After respectively determining all the individual ageing functions for the at least one battery stress factor, at box 1300, determining a cumulative ageing function based on all the individual ageing functions, and the ageing function describes a dependency of the pressure or strain values on each of the at least one battery stress factor.

It is possible to determine the cumulative ageing function based on an optimization or machine learning approach using the individual ageing functions as inputs. Thus, while the individual ageing functions sample the high dimensional input space of the cumulative ageing function locally, they can be used as support points for a fitting / optimization process of the cumulative ageing function. The cumulative ageing function can be a high-dimensional polynomial function.

It has been found that there is a general trend for the pressure or strain to increase over the lifetime of the battery, i.e., as ageing - expressed by charge throughput Ah or time t or cycles n - progresses. This general trend of the pressure $P$ is modeled by the cumulative ageing function that describes the respective proportionality depending on the severity of the stress factors during lifetime:

$$P(\text{Ah}) = 1 + \alpha(\text{SOC,DOD,C-ch,C-dc,T}) \cdot \text{Ah}^{z_{mean}}$$

$$(3)$$

$z_{mean}$ is a factor between 0 and 1. It is empirically determined. It describes a evolution of the pressure as a function of progressed lifetime - here expressed as charge throughput Ah (but Ah could be replaced by t or n). Typically, $z_{mean}$ = 0.4 - 0.6. $z_{mean}$ = 0.5 would equate to a square root increase of the pressure.

$\alpha(\text{SOC,DOD,C-ch,C-dc,T})$ is also a value between 0 and 1.

It is empirically observed that for certain battery cells the pressure does not monotonically increase over lifetime (as modeled by Eq. 3), but rather initially drops, before increasing monotonically. To account for this initial drop, a correction cumulative ageing function $\alpha_{hockey}$ can be determined, this is shown in Eq. 4.

$$P(\text{Ah}) = 1 + \alpha * \text{Ah}^{z_{mean}} - \alpha_{hockey} * \exp^{-\text{Ah}}$$

$$(4)$$

The function $\alpha_{hockey}$ is the correction cumulative ageing function used to approximate the initial pressure drop. It is determined so that the pressure over lifetime initially has the shape of a hockey-slope function, i.e., initially drops and then increases.

Also $\alpha_{hockey}$ is cumulatively dependent on multiple stress factors.

$$\alpha_{hockey} = \alpha_{hockey}(\emptyset\text{SOC, DOD,C-Ch,C-Dc}, \emptyset\text{T})$$

$$(5)$$

Also $\alpha_{hockey}$ can be determined similarly as $\alpha$.

The overall equation 4 including the sum of the term including the cumulative ageing function $\alpha$ and the term including the correction cumulative ageing function $\alpha_{hockey}$ corresponds to a model for determining pressure or strain values over the lifetime of the battery, parameterized depending on the stress factors and dependent on the progression of ageing (here expressed as charge throughput Ah). The pressure or strain values of the model initially decrease and then increase monotonous over the lifetime.

The strength of this initial decrease is regulated by the correction cumulative ageing function. For some battery cells, it is observed that there is no initial decrease, in which case the correction cumulative ageing function has a value of zero. Since the correction cumulative ageing function also depends on the multiple stress factors, varying strengths of the initial decrease of the pressure depending on the presence or absence of stress factors can be modeled. For instance, as illustrated in FIG. 1A and FIG. 1B, for certain SOC values an initial decrease of the pressure is observed (marked with the arrow in FIG. 1A); while no initial decrease of the pressure is observed for temperature stress.

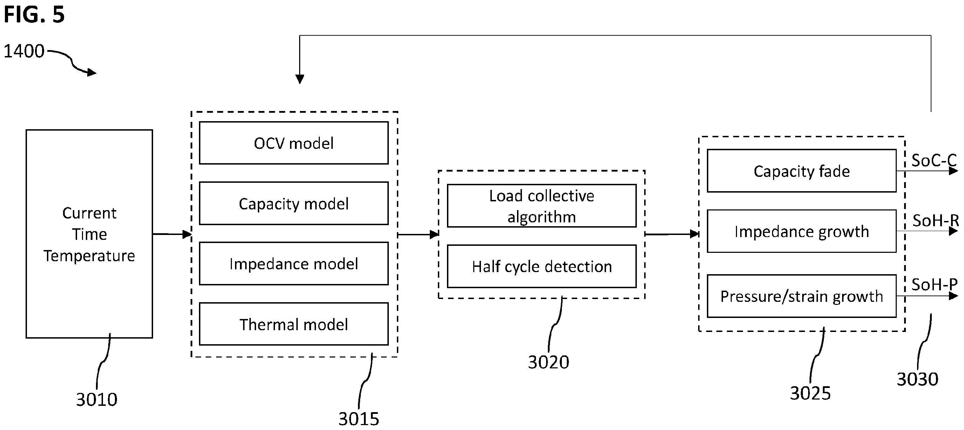

According to various examples, the method 1000 further includes - at box 1400 - determining, based on the ageing function, the pressure or strain values of a further cell of the rechargeable battery or another rechargeable battery. The SoH associated with pressure can be determined. In other words, the ageing function - determined for a certain battery type - can then be used in an application phase to determine the state of health of other rechargeable batteries of the same type. An example is illustrated in FIG. 5.

FIG. 5 corresponds to an application phase where a pre-built model of pressure or strain values over the lifetime of a battery is employed to determine the pressure or strain values and based on this the associated state of health of the battery.

The cumulative ageing function $\alpha$(SOC,DOD,C-ch,C-dc,T) is employed. This cumulative ageing function describes the proportionality of the pressure or strain values on progressed ageing throughout the lifetime. The cumulative ageing function depends on multiple stress factors.

FIG. 5 illustrates a processing pipeline for determining the state of health of the battery. Briefly, at 3030 the state of health associated with capacity, the state of health associated with impedance, as well as the state of health associated with the pressure/strain increase is determined.

For this, a pressure/strain model is used at box 3025 that predicts the pressure/strain in the battery. The pressure/strain and the battery can then be compared to a reference to yield the state of health associated with pressure. The growth of pressure/strain can be quantified by the state of health associated with pressure. I.e., larger pressure or strain corresponds to a larger reduction of the state of health associated with pressure or strain. In particular, the model of Equation 4 can be employed.

The processing of FIG. 5 is explained in detail below.

Measurements provided as input at box 3010 pertain to current and/or voltage measured at one or more battery cells. Also, timestamps are provided. Optionally, temperature measurements are provided. Such information can be provided as part of the state data 41 (cf. FIG. 3).

Thus, online condition monitoring of the state of health of the battery is enabled, based on field data obtained from a battery.

Such state data is then processed at box 3015. In particular, and open-circuit voltage of the one or more battery cells for which the state data is available is determined using a respective open-circuit voltage model. For instance, respective techniques are disclosed in DE 10 2021 105 784 A1, the respective disclosure being incorporated herein in its entirety.

Also, the capacity and the impedance of the battery cell or battery cells can be determined. For this, an equivalent circuit model of the battery can be considered. Techniques for calculating the impedance of the battery are disclosed, e.g., in EP 4 109 117 A1 in the respective disclosure is incorporated herein in its entirety.

Furthermore, a thermal model is considered that can be used to determine the internal temperature at one or more battery cells. Respective techniques are disclosed, e.g., in US 2022/0374568 A1. The disclosure is incorporated herein in its entirety.

Accordingly, in other words, at box 3015, state parameters of the battery that are not directly observable through measurements are determined using respective models. This is done based on a characteristic fingerprint of the current and/or voltage and temperature time dependency of the battery.

Then, at box 3020, further information of the operation of the battery in accordance with one or more battery stress factors is accumulated. Battery stress factors are tracked. The battery stress factors can be reported by the battery management system of the battery. The battery stress factors can be provided as state data 41 (cf. FIG. 3). The battery stress factors can, in particular, be derived from the measurement data continuously obtained throughout the observation period based on the models of box 3015. For instance, the state of charge, the depth of discharge, the sea-rate, and/or the temperature can be tracked. A load collective can be determined. This means that the relative frequency of occurrence of operating the battery at certain stress factor regimes, e.g., at certain depth of discharge - state of charge operating points, is tracked. The particular time at which the battery was operated at such operating point can be discarded. Half cycles of the battery, e.g., charging only or discharging only, can be determined. Such half cycles enable to determine the depth of discharge.

The half cycle algorithm at box 3020 counts and classifies charge and discharge throughput during cyclic operation. It is used to detected shallow cycles and recuperation during operation of a load connected to the battery, e.g., during driving of a battery-powered electric vehicle. This is done to determine charge throughput Ah or cycle count n.

Half-cycles calculate the SoC and DoD for a period of a couple of hours, e.g., 6h for the ageing model. Differently, the electrical/thermal, model runs with a higher time resolution, e.g., 1s resolution to cover dynamics.

Such information regarding the operation of the battery can then serve as an input into the processing at box 3025. Here, the capacity fade, the impedance growth, and the pressure/strain growth are determined. The pressure/strain growth is determined based on the model including the cumulative ageing function as explained above in connection with Equation 4.

Techniques to determine the capacity fade and impedance growth are readily available and the prior art.

Based on these calculations at box 3025, the up-to-date state of health associated with capacity, impedance and pressure/strain can be output at 3030. It would be optionally possible to feedback such information regarding the state of health to the modeling of the battery at box 3015, to update the calculation of the open-circuit model, the capacity, the impedance of the temperature.

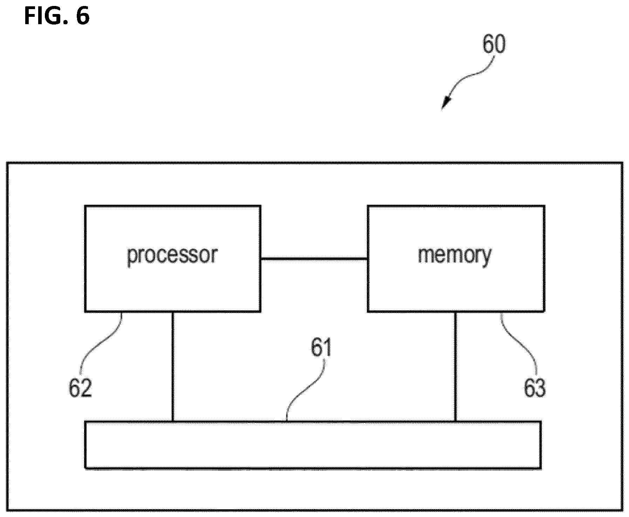

FIG. 6 is a block diagram of a computing device 60 according to various examples. The computing device 60 may comprise a processor 62, a memory 63, and an input/output interface 61. The processor 62 is configured to load program code from the memory 63 and execute the program code. Upon executing the program code, the processor 62 performs the method 1000 for processing determining a pressure or strain ageing model, e.g., an ageing function, of the test cell of a battery. Alternatively or additionally the processor 62 performs techniques associated with employing the ageing function for determining the state of health associated with pressure/strain of the battery as explained above in connection with FIG. 5.

The computing device 60 may be implemented by the computing device 81 of FIG. 3.

Summarizing, techniques have been described that facilitate determination of an evolution of pressure or strain of a battery. The techniques disclosed herein determine an ageing function based on a respective individual ageing function associated with each of at least one battery stress factor. For each of at least one battery stress factor, the respective individual ageing function is determined based on respective multiple sets of the pressure or strain (or stress) values. By utilizing a two-step approach for determining an ageing function that describes a dependency of pressure or strain values over a lifetime of a battery on at least one battery stress factor, e.g., an SoC, a DoD, a C-rate, or a T. Accordingly, an evolution of pressure or strain of the battery can be reliably and precisely determined/predicted and thereby the performance of the battery may be improved.

Although the invention has been shown and described with respect to certain preferred embodiments, equivalents and modifications will occur to others skilled in the art upon the reading and understanding of the specification. The present invention includes all such equivalents and modifications and is limited only by the scope of the appended claims.

## Claims

1. A computer-implemented method (1000) of characterizing ageing of a rechargeable battery, the method comprising: for each of at least one battery stress factor:

   - obtaining (1100) multiple sets of pressure or strain values over a lifetime of a test cell of a rechargeable battery;
   - determine (1200) a respective individual ageing function based on the respective multiple sets of the pressure or strain values, wherein the respective individual ageing function describes a dependency of the pressure or strain values on the respective battery stress factor;
   - determining (1300) a cumulative ageing function based on all the individual ageing functions, wherein the cumulative ageing function describes a dependency of the pressure or strain values on each of the at least one battery stress factor.

2. The computer-implemented method (1000) of claim 1, wherein, for each of the at least one battery stress factor, the respective individual ageing function is determined by fitting parameters of a predetermined parameterized function based on the respective multiple sets of the pressure or strain values, and the predetermined parameterized function describes an evolution of the pressure or strain values over the respective battery stress factor.

3. The computer-implemented method (1000) of claim 1 or 2, wherein the cumulative ageing function is determined by fitting parameters of a respective predetermined parameterized function based on the individual ageing functions.

4. The computer-implemented method (1000) of any one of the preceding claims, wherein the cumulative ageing function describes a proportionality of the pressure or strain values on progressed ageing throughout the lifetime.

5. The computer-implemented method (1000) of any one of the preceding claims, further comprising:

   - determining a correction cumulative ageing function associated with an initial drop of the pressure or strain values as ageing begins.

6. The computer-implemented method of claim 5,

   - building a model of the pressure or strain values over the lifetime of the battery based on a sum of a first term including the cumulative ageing function and a second term including the correction cumulative ageing function.

7. The computer-implemented method (1000) of any of the preceding claims,
   wherein each of the multiple sets of the pressure or strain values is obtained based on case stress measurements of the test cell.

8. The computer-implemented method (1000) of any of the preceding claims,
   wherein each of the multiple sets of the pressure or strain values is obtained during a cycling test or a calendric test of the test cell.

9. The computer-implemented method (1000) of any of the preceding claims,
   wherein the at least one battery stress factor comprises a state of charge, SoC, a depth of discharge, DoD, a C-rate, a charging C-Rate, a discharging C-rate, or a temperature.

10. A computer-implemented method of characterizing ageing of a battery, the method comprising:

    - obtaining, for a battery, data indicative of occurrence of multiple battery stress factors over a monitoring time duration,
    - based on the data indicative of occurrence of the multiple battery stress factors: determining at least one first state of health of the battery associated with at least one of capacity or impedance of the battery, and
    - based on the data indicative of occurrence of the multiple battery stress factors: determining a second state of health of the battery associated with pressure or strain of the battery.

11. The computer-implemented method of claim 10,
    wherein the second state of health is determined based on a cumulative ageing function describes a proportionality of the pressure or strain values on progressed ageing throughout a lifetime of the battery and depending on multiple stress factors.

12. The computer-implemented method of claim 11,
    wherein the second state of health is further determined based on a correction cumulative ageing function associated with an initial drop of the pressure or strain values as ageing begins.

13. The computer-implemented method of claim 11 or 12,
    wherein the cumulative ageing function is determined using the computer-implemented method of any one of claims 1 to 9.

14. The computer-implemented method of any one of claims 10 to 13,
    wherein the second state of health is determined based on the model of claim 6.

15. A computer program comprising program code executable by at least one processor, wherein the at least one processor, upon executing the program code, performs the method (1000) of any one of the preceding claims.

**FIG. 1A**

**FIG. 1B**

FIG. 2

**FIG. 3**

**FIG. 4**

1000

```
        ┌─────────────┐
        │    start    │
        └─────────────┘
               │
               ▼
        the last battery stress          Yes
             factor?
               │
              No
               │
               ▼
```

1100

obtaining multiple sets of pressure or strain values over a lifetime of a test cell of a rechargeable battery

1200

determine an individual ageing function based on the multiple sets of the pressure or strain values

the next battery stress factor

1300

determining a cumulative ageing function based on all the individual ageing functions

1400

applying ageing function for SOH determination

**FIG. 5**

**FIG. 6**

Europäisches
Patentamt

European
Patent Office

Office européen
des brevets

# EUROPEAN SEARCH REPORT

Application Number

EP 23 15 6523

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/160302 A1 (XU JEFF QIANG [US] ET AL) 11 June 2015 (2015-06-11) * paragraphs [0005] - [0007], [0018] - [0043] * | 1-9 | INV. H01M10/42 H01M10/48 G01R31/36 |
| X | DE 10 2018 120111 A1 (VOLKSWAGEN AG [DE]) 20 February 2020 (2020-02-20) * paragraphs [0001], [0002], [0005] - [0010], [0027] * | 1 | |
| A | US 2022/373609 A1 (BAUMANN MICHAEL [DE]) 24 November 2022 (2022-11-24) * abstract * | 1-9 | |
| A | WO 2019/053131 A1 (ABB SCHWEIZ AG [CH]) 21 March 2019 (2019-03-21) * abstract * | 1-9 | |

TECHNICAL FIELDS
SEARCHED      (IPC)

H01M
G01R

The present search report has been drawn up for all claims

| Place of search | Date of completion of the search | Examiner |
|---|---|---|
| Munich | 4 August 2023 | Mercedes González |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
..........................................................................................
& : member of the same patent family, corresponding
    document

EPO FORM 1503 03.82 (P04C01)

Europäisches
Patentamt

European
Patent Office

Office européen
des brevets

**Application Number**

**EP 23 15 6523**

---

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

---

## LACK OF UNITY OF INVENTION

The Search Division considers that the present European patent application does not comply with the requirements of unity of invention and relates to several inventions or groups of inventions, namely:

    see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

    1-9

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 23 15 6523

The Search Division considers that the present European patent application does not comply with the
requirements of unity of invention and relates to several inventions or groups of inventions, namely:

1. claims: 1-9

   A computer-implemented method of characterizing ageing of a
   rechargeable battery, the method comprising: for each of at
   least one battery stress factor:- obtaining (1100) multiple
   sets of pressure or strain values over a lifetime of a test
   cell of a rechargeable battery;- determine (1200) a
   respective individual ageing function based on the
   respective multiple sets of the pressure or strain values,
   wherein the respective individual ageing function describes
   a dependency of the pressure or strain values on the
   respective battery stress factor;- determining (1300) a
   cumulative ageing function based on all the individual
   ageing functions, wherein the cumulative ageing function
   describes a dependency of the pressure or strain values on
   each of the at least one battery stress factor.
   ---

2. claims: 10-15

   A computer-implemented method of characterizing ageing of a
   battery, the method comprising:- obtaining, for a battery,
   data indicative of occurrence of multiple battery stress
   factors over a monitoring time duration,- based on the data
   indicative of occurrence of the multiple battery stress
   factors: determining at least one first state of health of
   the battery associated with at least one of capacity or
   impedance of the battery, and- based on the data indicative
   of occurrence of the multiple battery stress factors:
   determining a second state of health of the battery
   associated with pressure or strain of the battery.
   ---

22

## ANNEX TO THE EUROPEAN SEARCH REPORT
## ON EUROPEAN PATENT APPLICATION NO.

EP 23 15 6523

This annex lists the patent family members relating to the patent documents cited in the above-mentioned European search report.
The members are as contained in the European Patent Office EDP file on
The European Patent Office is in no way liable for these particulars which are merely given for the purpose of information.

04-08-2023

| Patent document cited in search report | | Publication date | Patent family member(s) | | Publication date |
|---|---|---|---|---|---|
| US 2015160302 | A1 | 11-06-2015 | NONE | | |
| DE 102018120111 | A1 | 20-02-2020 | NONE | | |
| US 2022373609 | A1 | 24-11-2022 | DE 102019125375 A1 | | 25-03-2021 |
| | | | EP 4031886 A1 | | 27-07-2022 |
| | | | US 2022373609 A1 | | 24-11-2022 |
| | | | WO 2021052540 A1 | | 25-03-2021 |
| WO 2019053131 | A1 | 21-03-2019 | AU 2018331966 A1 | | 20-08-2020 |
| | | | CN 111095663 A | | 01-05-2020 |
| | | | EP 3682502 A1 | | 22-07-2020 |
| | | | JP 7266587 B2 | | 28-04-2023 |
| | | | JP 2020533772 A | | 19-11-2020 |
| | | | US 2020227791 A1 | | 16-07-2020 |
| | | | WO 2019053131 A1 | | 21-03-2019 |

EPO FORM P0459

For more details about this annex : see Official Journal of the European Patent Office, No. 12/82

**EP 4 418 404 A1**